# EUROPEAN PATENT APPLICATION

(11) **EP 4 839 029 A1**
(43) Date of publication of application: **11.11.2026**
(21) Application number: 25736308.5
(22) Date of filing: 03.01.2025
(51) Int. Cl.: H05K 3/18, H05K 3/06, H05K 1/11, H01L 23/12

(54) **CIRCUIT BOARD, AND SEMICONDUCTOR PACKAGE COMPRISING SAME**

(30) Priority: 03.01.2024 KR 20240001021; 23.12.2024 KR 20240194508
(71) Applicant: LG Innotek Co., Ltd., Seoul 07796 (KR)
(72) Inventor: NAM, Il Sik, Seoul 07796 (KR)
(74) Representative: Plasseraud IP
(86) International application number: PCT/KR2025/000158
(87) International publication number: WO 2025/147154

(57) **Abstract**

A circuit substrate according to an embodiment includes a build-up insulating structure including a plurality of insulating layers stacked in a vertical direction, a first pad disposed on a first region of the build-up insulating structure, and a second pad disposed on an upper surface of the first pad, wherein the first pad includes a concave portion recessed inward from a side surface of the first pad, and the concave portion may vertically overlap the second pad.

## Description

### [Technical Field]

An embodiment relates to a circuit substrate and a semiconductor package including the same.

### Background Art

As high performance of electrical/electronic products progresses, technologies for arranging a greater number of semiconductor elements on a circuit substrate of a limited size have been proposed and studied. However, since a general semiconductor package is based on mounting one semiconductor element, there is a limitation in obtaining desired performance.

Accordingly, recently, a semiconductor package in which a plurality of semiconductor elements are arranged using a plurality of substrates has been provided. Such a semiconductor package has a structure in which a plurality of semiconductor elements are connected to each other in a horizontal direction and/or a vertical direction on a circuit substrate. Accordingly, the semiconductor package has an advantage in that a mounting area of the semiconductor elements is efficiently used and high-speed signal transmission is possible through a short signal transmission path between the semiconductor elements.

Meanwhile, the circuit substrate includes a build-up insulating structure including an insulating layer and a build-up wiring structure disposed on the build-up insulating structure. For example, the circuit substrate may mean that a mounting position of each semiconductor element is predetermined in order to mount at least one semiconductor element, and a build-up wiring structure connected to the semiconductor element is disposed on the build-up insulating structure. The build-up wiring structure includes a wiring layer disposed on a surface of each insulating layer and a via electrode for connecting each wiring layer in a vertical direction. The semiconductor element is mounted on the circuit substrate and can transmit and receive signals through the build-up wiring structure.

Meanwhile, in a conventional circuit substrate, a protective layer partially covering a pad for connection with an external chip is formed and a connection part such as a solder ball is connected, but due to insufficient adhesion between the pad and the protective layer, a gap occurs between the protective layer and the pad due to warpage of the circuit substrate or external impact. Accordingly, there is a problem that the pad is damaged by external contaminants, and a fixing force of the solder ball connected on the pad is also reduced, thereby decreasing electrical reliability.

In addition, in the conventional circuit substrate, since the pad for connection with the external chip includes the same material as a seed layer, there is a problem that an upper portion of the pad is also etched in a process of etching the seed layer exposed on a surface of the build-up insulating structure. Accordingly, a recess is formed on a surface of the pad in contact with the connection part, thereby greatly increasing electrical resistance and causing signal loss. In addition, a thickness of the pad in contact with the connection part is reduced, thereby causing a connection defect with the external chip, or a height difference of pads according to regions in a horizontal direction of the circuit substrate occurs, thereby causing defects in mounting and assembling processes of the chip.

### [Disclosure]

### [Technical Problem]

One of technical problems of an embodiment is to prevent damage of a pad connected to an external chip in a circuit substrate.

In addition, one of technical problems of an embodiment is to prevent delamination between a pad connected to an external chip and a protective layer.

In addition, one of technical problems of an embodiment is to improve a fixing force between a pad connected to an external chip and a connection part.

In addition, one of technical problems of an embodiment is to prevent connection defects with an external chip in a circuit substrate.

Technical problems of the embodiment are not limited to those described in this section and include those that can be understood through the description of the invention.

### Technical Solution

A circuit substrate according to an embodiment includes a build-up insulating structure including a plurality of insulating layers stacked in a vertical direction; a first pad disposed on a first region of the build-up insulating structure; and a second pad disposed on an upper surface of the first pad, wherein the first pad includes a concave portion recessed inward from a side surface of the first pad, and the concave portion may vertically overlap the second pad.

In addition, in the embodiment, a horizontal width of a lower surface of the first pad may be greater than a horizontal width of an upper surface of the first pad.

In addition, in the embodiment, a horizontal width of the second pad may be smaller than the horizontal width of the lower surface of the first pad.

In addition, in the embodiment, the horizontal width of the upper surface of the first pad may be smaller than a horizontal width of a lower surface of the second pad.

In addition, in the embodiment, a thickness of the first pad may be greater than a thickness of the second pad.

In addition, in the embodiment, roughness of the upper surface of the second pad may be smaller than roughness of the concave portion.

In addition, the embodiment may further include a third pad disposed on a second region of the build-up insulating structure and a fourth pad disposed on the third pad.

In addition, in the embodiment, the third pad and the fourth pad may be grounded.

In addition, in the embodiment, the fourth pad includes a fourth-first pad and a fourth-second pad spaced apart from each other, and the fourth-first pad and the fourth-second pad may be connected through the third pad.

In addition, in the embodiment, the fourth pad may be provided on a side surface of the third pad and may include a second concave portion recessed from an upper surface toward a lower surface of the third pad.

In addition, in the embodiment, the third pad may include a plurality of third concave portions disposed between the fourth-first pad and the fourth-second pad.

In addition, in the embodiment, the first pad and the second pad may include different materials.

### [Advantageous Effects]

The circuit substrate according to the embodiment can prevent damage of a pad connected to an external chip.

For example, in the embodiment, a pad portion includes the first pad and the second pad, and since the second pad includes a material different from that of the first pad, the second pad is not etched during a seed layer etching process, so damage can be prevented.

In addition, the embodiment can prevent connection defects with an external chip.

For example, in the embodiment, since the thickness and the upper surface of the second pad connected to the external chip are not damaged, an open short problem during connection with the external chip can be prevented, and an increase in electrical resistance can be prevented.

In addition, the embodiment has a technical effect in that adhesion between a pad portion and a protective layer can be increased to prevent delamination.

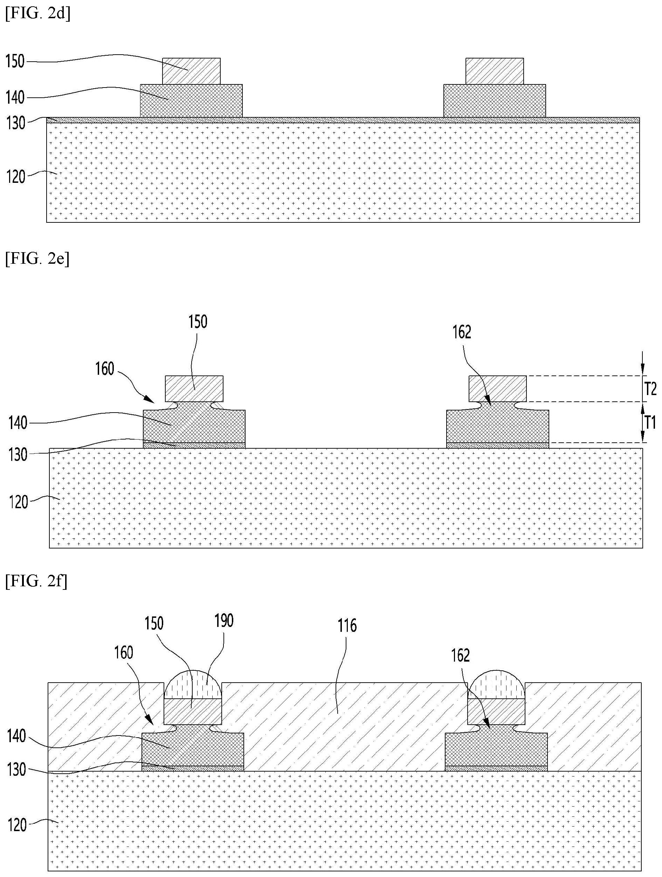

For example, referring to FIG. 2F, the embodiment includes a concave portion recessed inward from a side surface of the first pad, and as the concave portion exposes a lower surface of the second pad, the protective layer is disposed in the concave portion and also contacts the lower surface of the second pad, so adhesion between the pad portion and the protective layer can be improved.

In addition, the embodiment has a technical effect in that electrical reliability can be improved by improving a fixing force between a connection part and the pad portion.

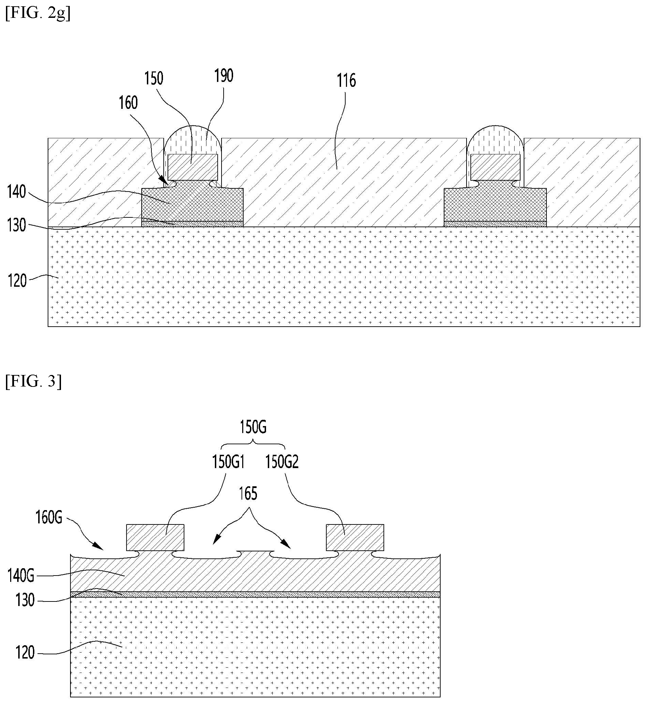

For example, referring to FIG. 2G, in the embodiment, as a concave portion recessed inward from a side surface of the first pad is formed, the connection part is disposed in the concave portion so that the connection part contacts not only a side surface of the second pad but also a lower surface thereof, thereby improving a fixing force between the connection part and the second pad.

In addition, the embodiment has a technical effect in that a height according to regions of the circuit substrate can be uniformly controlled.

For example, in the embodiment, during a process of etching the first metal layer, the second pad connected to the connection part is not etched so that a thickness thereof can be maintained, and heights of the second pad in an effective region and a ground region of the circuit substrate can be maintained to be the same.

Technical effects of the embodiment are not limited to those described in this section and include those that can be understood through the description of the invention.

### [Description of Drawings]

FIG. 1 is a cross-sectional view of a circuit substrate 100 according to an embodiment.
FIGS. 2A to 2G are process diagrams illustrating a manufacturing process of a first region A1 of FIG. 1.
FIG. 3 is a diagram illustrating a second region A2 of FIG. 1.
FIGS. 4A to 4C are electron microscope images of a circuit substrate according to an embodiment.
FIG. 5 is a diagram of a semiconductor package 101 according to a second embodiment.

### Mode for Invention

Hereinafter, preferred embodiments of the present invention will be described in detail with reference to the accompanying drawings.

However, the technical idea of the present invention is not limited to some embodiments described, but may be implemented in various different forms, and within the scope of the technical idea of the present invention, one or more of components among embodiments may be selectively combined or substituted.

In addition, terms used in embodiments of the present invention (including technical and scientific terms), unless clearly and specifically defined, may be interpreted as meanings generally understood by a person having ordinary skill in the art to which the present invention belongs, and terms generally used such as predefined terms may be interpreted considering meanings in the context of related technology. In addition, terms used in embodiments of the present invention are for describing the embodiments and are not intended to limit the present invention.

In the present specification, a singular form may include a plural form unless specifically stated in a phrase, and when described as "at least one of A and B, C", it may include at least one of all combinations that can be combined with A, B, and C. In addition, in describing components of embodiments of the present invention, terms such as first, second, A, B, a, and b may be used.

In the present specification, in describing components, for convenience of explanation, description may be made in a horizontal direction and a vertical direction. The vertical direction means upper or lower of each component, and the horizontal direction means a direction perpendicular to the vertical direction. In addition, the horizontal direction may include a first horizontal direction and a second horizontal direction. Here, when following a Cartesian coordinate system, the first horizontal direction may mean an X-axis, the second horizontal direction may mean a Y-axis, and the vertical direction may mean a Z-axis, and when following a cylindrical coordinate system, the first horizontal direction may mean a direction along an azimuth angle, and the second horizontal direction may mean a direction toward a radius, and these may be selectively used in combination. In addition, the direction along the azimuth angle may be referred to as a circumferential direction, and the direction toward the radius may be referred to as a radial direction.

These terms are only for distinguishing one component from another component, and do not limit essence, order, or sequence of the corresponding component. In addition, when a component is described as being "connected", "coupled", or "linked" to another component, it may include not only a case in which the component is directly connected, coupled, or linked to the other component, but also a case in which the component is "connected", "coupled", or "linked" due to another component interposed between the component and the other component.

In addition, the meaning that a component A is exposed from a component B should be understood as meaning that the component A is exposed from the component B, not that the component A is exposed from an entire product. That is, when it is described that the component A is exposed from the component B, it should be understood that at least a part of the component A is covered by a component C.

In addition, when it is described that a component A is in "contact" with a component B, it may include not only a case in which the component A is directly in "contact" with the component B, but also a case in which the component A is in "contact" with the component B due to another component interposed between the component A and the component B. Therefore, when it should be understood only as a case in which the component A is in "direct contact" with the component B, it is described as being in "direct contact".

In addition, when it is described that a component A is "covered" by a component B, it should be understood that a portion of the component A for achieving an intended function and purpose is covered by the component B, and unless there are special circumstances, it should not be understood that the entire component A is necessarily covered by the component B.

In addition, when it is described that a component A is "fixed" to a component B, it should be understood that not only the component A is directly coupled and fixed to the component B, but also, unless otherwise specified in consideration of an intended function and purpose, the component A is indirectly fixed to the component B through a component C and/or a component D. When it should be understood only as a case in which the component A is "directly fixed" to the component B, it is described as being "directly fixed".

In addition, when it is described that each component is formed or disposed on "upper" or "lower", the "upper" or "lower" includes not only a case in which two components are in direct contact with each other but also a case in which one or more other components are formed or disposed between the two components. In addition, when expressed as "upper" or "lower", it may include not only an upward direction but also a downward direction based on one component.

### (Embodiment)

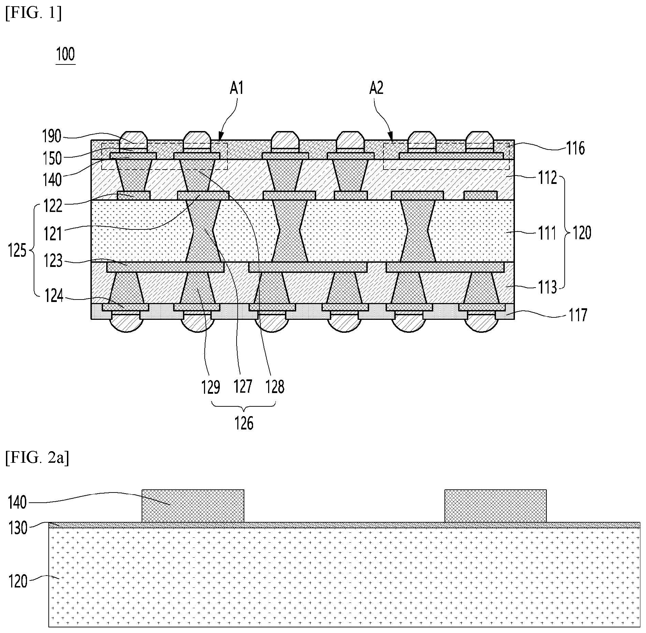

FIG. 1 is a cross-sectional view of a circuit substrate 100 according to an embodiment. Referring to FIG. 1, the circuit substrate 100 according to the embodiment may include a build-up insulating structure 120, a build-up wiring structure, and protective layers 116 and 117. The build-up insulating structure 120, the build-up wiring structure, and the protective layers 116 and 117 may be referred to as a build-up structure, but are not limited thereto. The build-up structure may perform a laminated circuit function for connection with an electronic device or a main board.

The build-up insulating structure 120 includes a single or a plurality of stacked insulating layers and provides insulation characteristics between build-up wiring structures. The build-up insulating structure 120 may be referred to as a build-up insulator. The build-up insulating structure 120 may include a first build-up insulating structure 111, a second build-up insulating structure 112, and a third build-up insulating structure 113, but is not limited thereto.

One of the build-up insulating structures 120 may be a core layer. The first build-up insulating structure 111 positioned at a center of the build-up insulating structure 120 may be the core layer, but is not limited thereto.

The core layer may secure overall mechanical rigidity of the circuit substrate to suppress occurrence of warpage. Since both warpage occurring during a process and warpage occurring during operation of a product can be suppressed, the core layer can improve a yield of the circuit substrate and can improve reliability of the circuit substrate.

The core layer may include a reinforcing member such as glass fiber extending in a horizontal direction and a resin surrounding the reinforcing member, and mechanical rigidity may be adjusted according to a density of the reinforcing member. The reinforcing members of the core layer may be stacked to be spaced apart from each other in a vertical direction and may be provided in a resin layer. According to another embodiment, the core layer may be formed of glass. When formed of glass, an effect that a density of via electrodes penetrating the core layer can be increased and an interval between via electrodes can be easily controlled may be obtained. In addition, there may be an advantage that the circuit substrate can be thinned due to higher mechanical rigidity than that of a resin including glass fiber. The core layer is not limited to the above and may be freely selected as long as it is a material capable of securing mechanical rigidity in consideration of yield and cost.

The build-up insulating structure 120 may include an upper build-up insulating structure disposed on an upper surface of the core layer and a lower build-up insulating structure disposed on a lower surface of the core layer. For example, the build-up insulating structure 120 may include the first build-up insulating structure 111 as the core layer, the second build-up insulating structure 112 as the upper build-up insulating structure disposed on the upper surface of the core layer, and the third build-up insulating structure 113 as the lower build-up insulating structure disposed on the lower surface of the core layer.

The upper build-up insulating structure and the lower build-up insulating structure each perform a function of disposing a wiring layer or a via electrode of the build-up wiring structure, a function of securing insulation between circuits, and a function of controlling impedance or insertion loss caused by circuits, and include an insulating layer including at least one of a thermosetting resin, a photocurable resin, or an optical isotropic film in consideration of dielectric constant, mechanical rigidity, and processability.

For example, the insulating layer of the build-up insulating structure 120 may be a thermosetting material and may include at least one of Ajinomoto Build-up Film (ABF), epoxy resin, polyimide, phenolic resin, BT (Bismaleimide Triazine) resin, and silicone resin.

In addition, for example, the insulating layer of the build-up insulating structure 120 may be a photocurable material and may include at least one of a photo imageable dielectric resin (PID), a photosensitive polyimide, a liquid photoimageable solder resist (LPI), a photosensitive epoxy, and a photosensitive acrylic.

For example, a photocurable resin may enable fine pattern formation of a through hole or an opening through exposure and development processes, and may remove a stopper required in a cavity formation process. Meanwhile, a content of ceramic particles such as SiO₂ included in an insulating layer of the photocurable resin may be higher than a content of ceramic particles included in an insulating layer of a thermosetting resin, and accordingly an interface between the photocurable resin and the thermosetting resin may be distinguished. For example, when XPS (X-ray Photoelectron Spectroscopy) analysis of the photocurable resin is performed, relatively high power peak values may be detected in two components of acrylic and epoxy. In addition, when XPS analysis of the thermosetting resin is performed, a peak value may be detected only in epoxy.

In addition, the insulating layer of the build-up insulating structure 120 may include an optical isotropic film, and may include at least one of COC (Cyclic Olefin Copolymer), COP (Cyclic Olefin Polymer), optical isotropic polycarbonate (polycarbonate, PC), and optical isotropic polymethyl methacrylate (PMMA).

In addition, the insulating layer of the build-up insulating structure 120 may include prepreg, and through this, may have strength of a predetermined level or higher capable of improving warpage characteristics of the circuit substrate. The prepreg constituting the insulating layer may have a structure in which a resin such as epoxy resin is impregnated into a glass fiber layer in a form of a fabric sheet such as glass fabric.

Next, the build-up wiring structure of the circuit substrate 100 includes a wiring layer 125 disposed on a surface of each insulating layer and a via electrode 126 for connecting each wiring layer 125 in a vertical direction. The wiring layer 125 may perform a function of transmitting a signal and/or power to a semiconductor element disposed on the circuit substrate 100 and an impedance matching function. The wiring layer 125 may be referred to as a wiring pattern layer, a metal wiring, or a wiring portion.

The via electrode 126 may include a plurality of first via electrodes 127, second via electrodes 128, and third via electrodes 129 formed in through holes penetrating the first build-up insulating structure to the third build-up insulating structure 111, 112, and 113, respectively. The via electrode 126 may electrically connect between wiring layers 125 disposed on different layers.

The via electrode 126 is formed in through holes penetrating insulating layers, and the through holes may be formed by any one of mechanical processing, laser processing, or chemical processing. When the through holes are formed by mechanical processing, methods such as milling, drilling, and routing may be used. When formed by laser processing, UV or CO₂ laser methods may be used, and in chemical processing, chemicals including aminosilane and ketone may be used.

The via electrode 126 may be formed by forming through holes penetrating the insulating layers and filling an inside of the formed through holes with a conductive material.

When the through holes are formed, the via electrode 126 may be formed by filling the inside of the through holes with a conductive material. A metal material forming the via electrode 126 may be at least one selected from copper (Cu), silver (Ag), tin (Sn), gold (Au), nickel (Ni), and palladium (Pd). In addition, filling of the conductive material may be performed by any one or a combination thereof among electroless plating, electrolytic plating, screen printing, sputtering, evaporation, inkjetting, and dispensing.

Next, the circuit substrate 100 according to the embodiment includes the wiring layer 125 electrically connected to the via electrode 126. The wiring layer 125 includes a pad and/or a trace (or connection pattern) for connection with the via electrode 126 and/or a semiconductor element and/or a capacitor. The trace may be a signal wiring line connecting between a plurality of pads.

In this case, the pad of the wiring layer 125 includes a connection pad or a bonding pad. The connection pad may be a mounting pad on which an electronic element or a semiconductor chip is mounted, or a terminal pad connected to an external substrate. The bonding pad is a contact portion in contact with the via electrode and may include a side extension portion having a horizontal width greater than that of the trace for an alignment margin.

The wiring layer 125 may include a first wiring layer 121 electrically connected to an upper surface of the first via electrode 127, a second wiring layer 122 disposed on the first build-up insulating structure 111 and electrically connected to the second via electrode 128, a third wiring layer 123 connected to a lower surface of the first via electrode 127, and a fourth wiring layer 124 electrically connected to a lower surface of the third via electrode 129, but is not limited thereto.

The wiring layer 125 may be formed by a manufacturing process of the circuit substrate such as an additive process, a subtractive process, an MSAP (Modified Semi Additive Process), and an SAP (Semi Additive Process).

At least one of the above-described build-up wiring structures may have an ETS (Embedded Trace Substrate) structure. The ETS structure may be referred to as an embedded structure. The ETS structure may be advantageous for miniaturization compared to a build-up wiring structure having a general protruding structure. Accordingly, the embodiment enables formation of electrodes corresponding to sizes and pitches of terminals provided in the semiconductor element. Through this, the embodiment can improve circuit integration. Furthermore, the embodiment can minimize a transmission distance of a signal transmitted through the semiconductor element, and through this, can minimize signal transmission loss.

In addition, the build-up wiring structure may be formed of at least one metal material selected from gold (Au), silver (Ag), platinum (Pt), titanium (Ti), tin (Sn), copper (Cu), aluminum (Al), silicon (Si), and zinc (Zn). In addition, the build-up wiring structure may be formed of a paste or a solder paste including at least one metal material selected from gold (Au), silver (Ag), platinum (Pt), titanium (Ti), tin (Sn), copper (Cu), and zinc (Zn), which have excellent bonding strength.

Next, the circuit substrate 100 according to the embodiment includes protective layers 116 and 117 disposed on a wiring layer of an uppermost or lowermost insulating layer. For example, the protective layers 116 and 117 may include a first protective layer 116 disposed on the second build-up insulating structure 112 and a second protective layer 117 disposed under the third build-up insulating structure 113.

The protective layers 116 and 117 can prevent occurrence of problems such as oxidation or delamination of the build-up structure due to penetration of moisture and/or external contaminants. In addition, the protective layer is formed of a material having low wettability with solder to prevent a short circuit between adjacent solders when the build-up structure is connected to an electronic element or a main board, thereby preventing a bridge short circuit problem between adjacent solders.

In addition, the protective layers 116 and 117 include an insulating material and include various materials that can be cured by heating or light irradiation after being applied to protect surfaces of insulating layers and surfaces of wiring layers. The protective layers 116 and 117 may be a resist layer, and for example, the protective layers 116 and 117 may be a solder resist layer including an organic polymer material. For example, the protective layers 116 and 117 include a resin of an epoxy acrylate series. More specifically, the protective layers 116 and 117 include a resin, a curing agent, a photoinitiator, a pigment, a solvent, a filler, an additive, an acrylic monomer, and the like. However, the embodiment is not limited thereto, and the protective layers 116 and 117 may be any one of a photo solder resist layer, a cover-lay, and a polymer material.

Next, FIGS. 2A to 2G are process diagrams illustrating a manufacturing process of the first region A1 of FIG. 1. Hereinafter, a process of forming the first pad 140 and the second pad 150 on an upper side of the build-up insulating structure 120 in the circuit substrate will be mainly described.

The build-up insulating structure 120 of FIGS. 2A to 2E may include a plurality of insulating layers and may include a plurality of wiring layers and via electrodes as illustrated in FIG. 1.

First, referring to FIG. 2A, a first metal layer 130 may be formed on the build-up insulating structure 120. The first metal layer 130 may mean a copper foil layer disposed on the build-up insulating structure 120. In addition, the first metal layer 130 may be an electroless plating layer formed by performing electroless plating on the build-up insulating structure 120. For example, the first metal layer 130 may be a chemical copper plating layer. The first metal layer 130 may include both the copper foil layer and the chemical copper plating layer.

Subsequently, a first mask (not shown) may be formed on the first metal layer 130, and the first mask may include an open region for opening a region in which the first pad 140 is to be formed.

Thereafter, the first pad 140 filling the open region of the first mask may be formed using the first metal layer 130 as a seed layer. Subsequently, a process of removing the first mask may be performed.

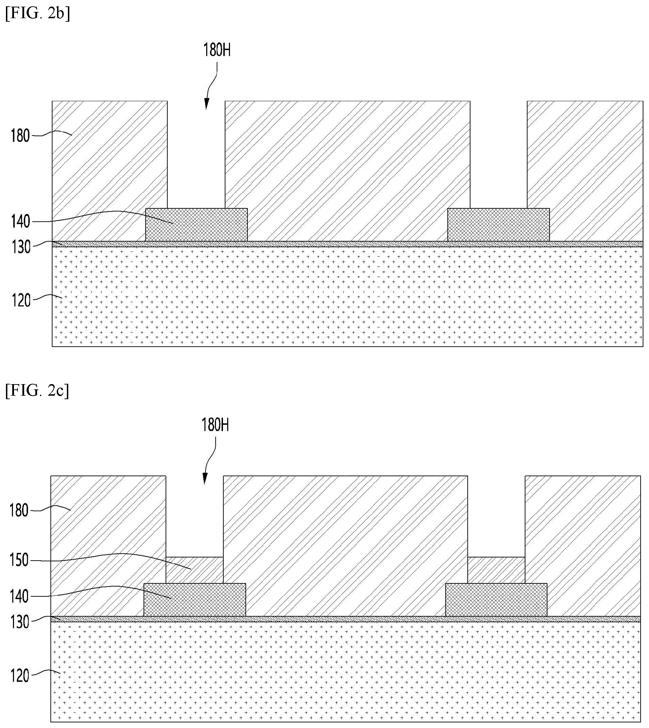

Next, referring to FIG. 2B, the embodiment may perform a process of forming a second mask 180 on the build-up insulating structure 120. The second mask 180 may be a dry film, but is not limited thereto. The second mask 180 may be formed on the first metal layer 130 and the first pad 140. The second mask 180 may include an open region 180H. The open region 180H of the second mask 180 may vertically overlap the first pad 140. An upper surface of the first pad 140 may be partially exposed by the open region 180H of the second mask 180.

Next, referring to FIG. 2C, the second pad 150 may be formed on the exposed upper surface of the first pad 140. The second pad 150 may be disposed on the upper surface of the first pad 140. The second pad 150 may be formed by performing electrolytic plating on the exposed upper surface of the first pad 140. The second pad 150 may include tin or an alloy including tin. For example, the second pad 150 may include SnAg, but is not limited thereto.

A horizontal width of the second pad 150 may be smaller than a horizontal width of the first pad 140. In addition, a thickness of the second pad 150 may be formed to be smaller than a thickness of the first pad 140.

Next, referring to FIG. 2D, a process of removing the second mask 180 may be performed in the embodiment.

Next, referring to FIG. 2E, the embodiment may perform a process of removing the first metal layer 130 disposed on the build-up insulating structure 120. A portion of the first metal layer 130 disposed in a region not vertically overlapping the first pad 140 may be removed. The process of removing the first metal layer may include organic etching. More specifically, in the embodiment, since etching using a general acid or alkali causes a problem in that not only the first metal layer 130 but also the second pad 150 is etched, organic etching using an organic acid may be performed.

Meanwhile, in a process of etching the first metal layer 130, the first pad 140 may also be partially etched. More specifically, a concave portion 160 recessed from an upper surface toward a lower surface of the first pad 140 may be formed. In addition, the concave portion 160 may be formed to be directed inward from a side surface of the first pad 140. The side surface of the first pad 140 may mean a side surface in a region not vertically overlapping the second pad 150. In addition, the inward direction of the first pad 140 may mean a direction toward a central region of the first pad 140 and may mean a direction from one side surface of the first pad 140 to another side surface opposite thereto.

In addition, the first pad 140 may include a protrusion 162 in a region in contact with the second pad 150. The protrusion 162 may vertically overlap the second pad 150. In addition, a horizontal width of the protrusion 162 may be less than or equal to a horizontal width of the second pad 150. In addition, a side surface of the protrusion 162 may have a concave shape directed inward.

As the concave portion 160 is formed, a horizontal width of the upper surface of the first pad 140 may be smaller than a horizontal width of the lower surface of the first pad 140. In addition, the horizontal width of the upper surface of the first pad 140 may be less than or equal to a horizontal width of a lower surface of the second pad 150. In addition, the horizontal width of the upper surface of the first pad 140 may be smaller than a horizontal width of the first metal layer 130. Accordingly, in the embodiment, only the first metal layer 130 and a part of the first pad 140 are etched due to an etching process, and the second pad 150 does not receive etching damage, so a thickness of the second pad 150 can be maintained, thereby preventing a wettability issue (Non-wet) of a connection part for connection with an external chip and preventing a connection defect.

In addition, the concave portion 160 may vertically overlap the second pad 150. Accordingly, a lower surface of the second pad 150 may be partially exposed by the concave portion 160.

When a connection part such as a solder ball is disposed on the second pad 150, the connection part may contact not only an upper surface and a side surface of the second pad 150 but also a lower surface of the second pad 150 exposed by the concave portion 160, so an electrical contact area can be improved, and an edge region of the second pad 150 exposed by the concave portion 160 performs an anchor function, thereby providing a technical effect in that the connection part can be fixed.

In addition, a first thickness T1 of the first pad 140 may be greater than a second thickness T2 of the second pad 150.

In addition, the first metal layer 130 may be electrically connected to a via electrode of the build-up insulating structure 120. In addition, the first pad 140 may vertically overlap a via electrode electrically connected to the first metal layer 130.

In addition, in the embodiment, since a part of the first pad 140 is etched and the second pad 150 is not etched, roughness of an upper surface of the second pad 150 may be smaller than roughness of the concave portion 160. Accordingly, in the embodiment, since the upper surface of the second pad 150 in contact with an external chip and/or a connection part is not damaged, an increase in electrical resistance can be prevented.

Next, referring to FIG. 2F, a protective layer 116 may be formed on the build-up insulating structure 120. The protective layer 116 may be disposed to cover a part of the first pad 140. In addition, the protective layer 116 may be disposed to contact a side surface of the second pad 150.

Meanwhile, the protective layer 116 may be formed to fill the concave portion 160. Accordingly, the protective layer 116 may also contact a lower surface of the second pad 150 exposed by the concave portion 160. The concave portion 160 may vertically overlap the second pad 150. Accordingly, the concave portion 160 may perform an anchor function so that the protective layer 116 can contact the lower surface of the second pad 150. Therefore, in the embodiment, a contact area between the protective layer 116 and the pad is increased by the concave portion 160 formed in the first pad 140, and the protective layer 116 contacts not only a side surface but also a lower surface of the second pad, thereby improving adhesion between the protective layer 116 and the pad.

Thereafter, a connection part 190 may be disposed on the second pad 150. Through the connection part 190, the second pad 150 may be connected to an external chip or substrate.

Next, FIG. 2G illustrates an embodiment in which the protective layer 116 of FIG. 2F is modified. Referring to FIG. 2G, the protective layer 116 may be disposed to cover a part of the first pad 140. Meanwhile, the protective layer 116 may be disposed to be spaced apart from the second pad 150 by a predetermined distance. In this case, when the connection part 190 is formed on the second pad 150, the connection part 190 may penetrate between the second pad 150 and the protective layer 116. In addition, the connection part 190 may be disposed to fill the concave portion 160. Accordingly, the connection part 190 may contact the upper surface, the side surface, and the lower surface of the second pad 150. The connection part 190 contacting the lower surface of the second pad 150 performs an anchor function, thereby providing a technical effect in that separation of the connection part 190 from the second pad 150 can be prevented. In addition, the embodiment provides a technical effect in that signal transmission speed can be improved as a contact area between the connection part 190 and the second pad 150 is increased.

FIG. 3 is a diagram illustrating the second region A2 of FIG. 1. The second region A2 of FIG. 1 may be a ground region. Referring to FIG. 3, the first metal layer 130 may be disposed on the build-up insulating structure 120. The first metal layer 130 may not be electrically connected to a via electrode or a wiring layer disposed in the build-up insulating structure 120.

A third pad 140G may be disposed on the first metal layer 130. A fourth pad 150G may be disposed on an upper surface of the third pad 140G. The third pad 140G and the fourth pad 150G may function as ground pads.

The fourth pad 150G may include a plurality of pads. For example, the fourth pad 150G may include a fourth-first pad 150G1 and a fourth-second pad 150G2 spaced apart from each other. The fourth-first pad 150G1 and the fourth-second pad 150G2 may be disposed on the same third pad 140G. The fourth-first pad 150G1 and the fourth-second pad 150G2 may be connected through the third pad 140G.

Meanwhile, referring briefly to FIG. 1, in the second region A2, an upper surface of the third pad 140G may be partially etched in a process of etching the first metal layer 130 of the first region A1. More specifically, a second concave portion 160G recessed from an upper surface toward a lower surface may be formed in the third pad 140G. In addition, a plurality of third concave portions 165 may be formed between the fourth-first pad 150G1 and the fourth-second pad 150G2.

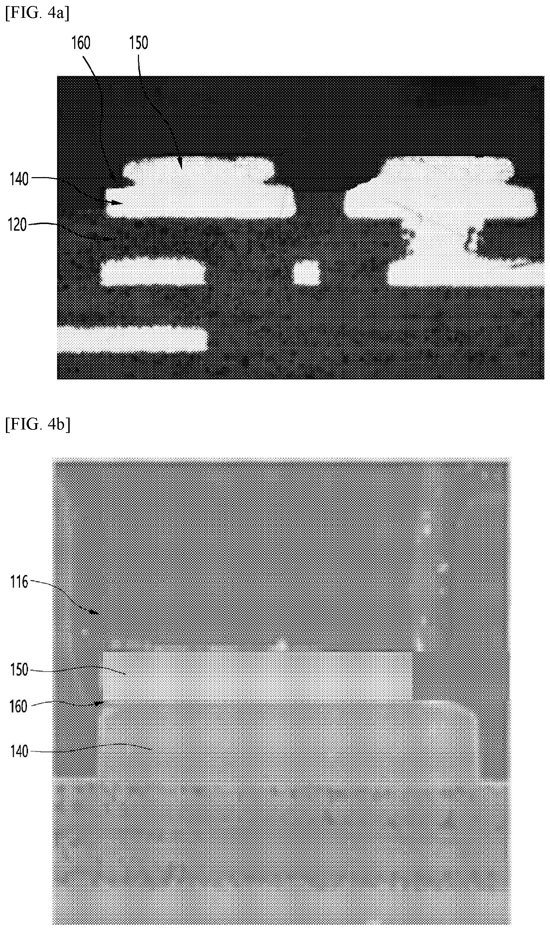

FIGS. 4A and 4B are electron microscope images of a circuit substrate according to an embodiment. First, referring to FIG. 4A, the circuit substrate according to the embodiment may include the first pad 140 and the second pad 150 on the build-up insulating structure 120.

Meanwhile, in the circuit substrate, the first pad 140 may be formed using the first metal layer 130 as a seed layer. In addition, the second pad 150 disposed on the first pad 140 may include a material different from that of the first pad 140.

Accordingly, in a process of etching the first metal layer 130, a part of the first pad 140 may be etched. More specifically, the first pad 140 may include a concave portion 160 recessed from an upper surface toward a lower surface. The concave portion 160 may vertically overlap the second pad 150. In addition, the concave portion 160 may contact a lower surface of the second pad 150. Meanwhile, the second pad 150 may not be etched. In addition, during the etching process of the first metal layer 130, roughness of an upper surface of the second pad 150 may be maintained.

In addition, referring to FIG. 4B, the second pad 150 may be disposed on the first pad 140. A horizontal width of the second pad 150 may be smaller than a horizontal width of the first pad 140. In addition, the first pad 140 may include a concave portion 160 recessed inward from a side surface. The concave portion 160 may contact a lower surface of the second pad 150. In addition, the protective layer 116 may be disposed to cover a part of the first pad 140. The protective layer 116 may cover a side surface and a part of an upper surface of the first pad 140 and may fill the concave portion 160. Accordingly, the protective layer 116 may contact a side surface and a lower surface of the second pad 150, thereby improving adhesion between the protective layer 116 and the pad.

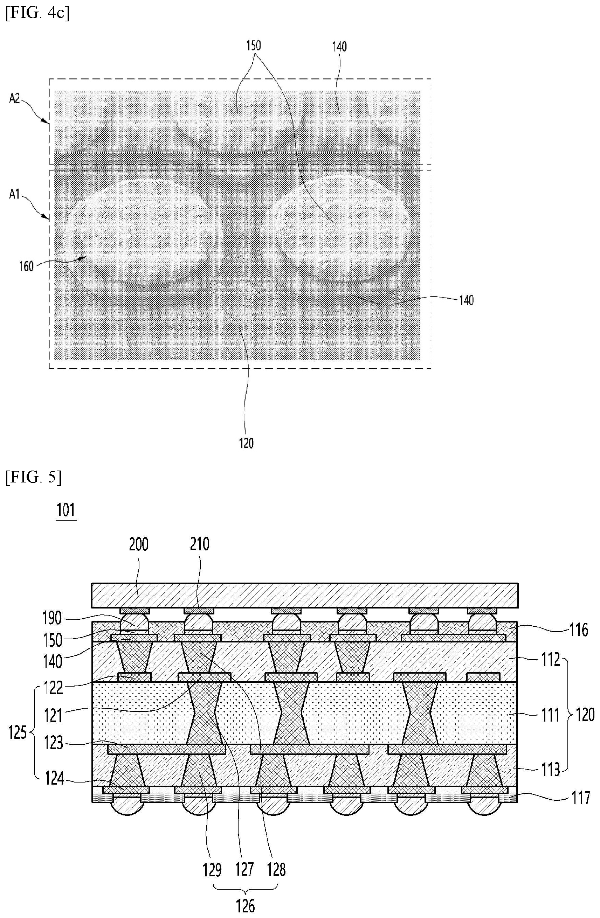

In addition, referring to FIG. 4C, the circuit substrate of the embodiment may include a first region A1 as a signal region and a second region A2 as a ground region. In the first region A1, the first pads 140 may be disposed to be spaced apart from each other. In addition, the second pad 150 may be disposed on the first pad 140, and a horizontal width of the second pad 150 may be smaller than a horizontal width of the first pad 140. In addition, a concave portion 160 recessed inward from a side surface of the first pad 140 may be formed, and the concave portion 160 may vertically overlap the second pad 150. In addition, the first pad 140 and the second pad 150 may include different materials. Accordingly, during seed layer etching, a part of the first pad 140 may be etched to form the concave portion 160, but the second pad 150 may not be etched.

In addition, the first region A1 and the second region A2 may be distinguished by the first pad 140. In the second region A2, the second pad 150 may be disposed on the same first pad 140. In addition, heights of upper surfaces of the second pad 150 in the first region A1 and the second pad 150 in the second region A2 may be the same.

FIG. 5 is a diagram of a semiconductor package 101 according to a second embodiment. The semiconductor package 101 of the second embodiment may include the circuit substrate 100 having the build-up structure of FIG. 1.

Referring to FIG. 5, the semiconductor package 101 according to the second embodiment may include the circuit substrate 100 and a chip 200 disposed on the circuit substrate 100. More specifically, in the circuit substrate 100, the second pad 150 may be disposed on the first pad 140 disposed on an outermost layer of the build-up insulating structure 120, and the first protective layer 116 exposing an upper surface of the second pad 150 may be disposed. In addition, a connection part 190 may be disposed on the exposed second pad 150. The connection part 190 may include a spherical shape. In addition, a cross section of the connection part 190 may include a circular shape or a semicircular shape. The connection part 190 may be a solder ball, but is not limited thereto.

In addition, the circuit substrate may further include a bonding portion on the first protective layer 116. The bonding portion may be disposed on an upper surface of the first protective layer 116 to perform thermal compression bonding with a semiconductor element, and may be used when it is difficult to implement with conventional solder bonding as a pitch of the first pad 140 of the semiconductor element becomes fine.

In addition, a chip 200 or an element may be included on the connection part 190 of the circuit substrate. The chip 200 may be a processor chip. For example, the chip 200 may be an application processor (AP) chip such as a central processor (e.g., CPU), a graphic processor (e.g., GPU), a digital signal processor, a cryptographic processor, a microprocessor, or a microcontroller. A lower surface of the chip 200 may include terminals 210, and the terminals 210 may include a plurality of terminals.

The terminals 210 of the chip 200 may be electrically connected to the connection part 190 of the circuit substrate.

Meanwhile, the semiconductor package 101 of the embodiment may include a plurality of chips disposed to be spaced apart from each other in a horizontal direction on one circuit substrate. For example, the chip 200 may include a first chip and a second chip. The first chip and the second chip may be application processor (AP) chips of different types.

In addition, in the semiconductor package 101 of the embodiment, a connection part located at a lower portion may be for coupling a main board (or motherboard) of an external device.

### Industrial Applicability

The circuit substrate or the semiconductor package according to the embodiment can be applied to any one of CSP (Chip Scale Package), FC-CSP (Flip Chip-Chip Scale Package), FC-BGA (Flip Chip Ball Grid Array), POP (Package On Package), and SIP (System In Package).

In addition, the circuit substrate or the semiconductor package can be applied to a smart phone, a personal digital assistant, a digital video camera, a digital still camera, a vehicle, a high-performance server, a network system, a computer, a monitor, a tablet, a laptop, a netbook, a television, a video game, a smart watch, and automotive applications, but is not limited thereto.

Features, structures, effects, and the like described in the above embodiments are included in at least one embodiment of the present invention and are not necessarily limited to only one embodiment. Furthermore, features, structures, effects, and the like exemplified in each embodiment may be combined or modified with respect to other embodiments by those having ordinary skill in the art to which the embodiments belong. Accordingly, matters related to such combinations and modifications should be interpreted as being included in the scope of the present invention.

In addition, although the embodiments have been described above mainly with reference to embodiments, this is only an example and does not limit the present invention, and those having ordinary skill in the art to which the present invention belongs will understand that various modifications and applications not exemplified above are possible without departing from the essential characteristics of the present embodiment. For example, each component specifically shown in the embodiments may be modified and implemented. In addition, differences related to such modifications and applications should be interpreted as being included in the scope of the present invention defined in the appended claims.

## Claims

1. A circuit substrate, comprising:
a build-up insulating structure including a plurality of insulating layers stacked in a vertical direction;
a first pad disposed on a first region of the build-up insulating structure; and
a second pad disposed on an upper surface of the first pad,
wherein the first pad comprises a concave portion recessed inward from a side surface of the first pad,
and the concave portion vertically overlaps the second pad.

2. The circuit substrate according to claim 1,
wherein a horizontal width of a lower surface of the first pad is greater than a horizontal width of the upper surface of the first pad.

3. The circuit substrate according to claim 1,
wherein a horizontal width of the second pad is smaller than a horizontal width of a lower surface of the first pad.

4. The circuit substrate according to claim 1,
wherein a horizontal width of the upper surface of the first pad is smaller than a horizontal width of a lower surface of the second pad.

5. The circuit substrate according to claim 1,
wherein a thickness of the first pad is greater than a thickness of the second pad.

6. The circuit substrate according to claim 1,
wherein roughness of an upper surface of the second pad is smaller than roughness of the concave portion.

7. The circuit substrate according to claim 1,
further comprising a third pad disposed on a second region of the build-up insulating structure, and
a fourth pad disposed on the third pad,
wherein the third pad and the fourth pad are grounded,
wherein the fourth pad comprises a fourth-first pad and a fourth-second pad spaced apart from each other, and
the fourth-first pad and the fourth-second pad are connected through the third pad.

8. The circuit substrate according to claim 7,
wherein the fourth pad is provided on a side surface of the third pad, and comprises a second concave portion recessed from an upper surface toward a lower surface of the third pad.

9. The circuit substrate according to claim 1,
wherein the first pad and the second pad comprise different materials.

10. A semiconductor package, comprising:
the circuit substrate of any one according to claims 1 to 10.
